(19) Europäisches Patentamt
European Patent Office
Office européen des brevets

(11) **EP 2 681 776 B1**

(12) **FASCICULE DE BREVET EUROPEEN**

(45) Date de publication et mention
de la délivrance du brevet:
**26.02.2020 Bulletin 2020/09**

(51) Int Cl.:
*H01L 31/18* [(2006.01)] *H01L 21/033* [(2006.01)]
*H01L 31/0236* [(2006.01)]

(21) Numéro de dépôt: **12708525.6**

(22) Date de dépôt: **05.03.2012**

(86) Numéro de dépôt international:
**PCT/EP2012/053760**

(87) Numéro de publication internationale:
**WO 2012/119990 (13.09.2012 Gazette 2012/37)**

(54) **PROCEDE DE METALLISATION DE SURFACES TEXTUREES**

VERFAHREN ZUR METALLISIERUNG VON STRUKTURIERTEN OBERFLÄCHEN

METHOD FOR METALLIZING TEXTURED SURFACES

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **04.03.2011 FR 1151755**

(43) Date de publication de la demande:
**08.01.2014 Bulletin 2014/02**

(73) Titulaire: **Commissariat à l'Énergie Atomique et aux Énergies Alternatives
75015 Paris (FR)**

(72) Inventeurs:
• **PERNEL, Carole**
**F-38120 Saint-Egrève (FR)**
• **CHAIX, Nicolas**
**F-38410 Saint Martin d'Uriage (FR)**
• **LANDIS, Stefan**
**F-38500 Voiron (FR)**

(74) Mandataire: **Hautier, Nicolas
Cabinet Hautier
20, rue de la Liberté
06000 Nice (FR)**

(56) Documents cités:
EP-A1- 2 068 373    US-A1- 2010 120 191
US-B1- 7 235 474

• JAGER K ET AL: "Light scattering properties of surface-textured substrates", PHYSICA STATUS SOLIDI. C: CURRENT TOPICS IN SOLID STATE PHYSICS, vol. 7, no. 3-4, 1 avril 2010 (2010-04-01), pages 945-948, XP009162833, WILEY - VCH VERLAG GMBH & CO. KGAA, DE ISSN: 1862-6351, DOI: 10.1002/PSSC.200982695
• S.M.Sze: "Semiconductor Devices, Physics and Technology", 31 décembre 1985 (1985-12-31), Bell Telephone Laboratories, USA, XP002683641, ISBN: 0-471-87424-8 page FP, le document en entier
• Chopra & Das: "Thin film solar cells", 31 décembre 1983 (1983-12-31), Plenum Press, London, XP002668244, pages 261-264, figure 43 et le texte correspondant
• Coutts & Meakin: "Current topics in Photovoltaics", 31 décembre 1985 (1985-12-31), Academic Press, London, XP002668243, pages 156-158, les sections 5.3.6.2a et 5.3.6.2b

EP 2 681 776 B1

## Description

La présente invention concerne un procédé de réalisation de motifs conducteurs ou semi conducteurs d'électricité sur une surface texturée d'une cellule photovoltaïque.

La fabrication industrielle de dispositifs semi-conducteurs du type circuits intégrés se fait traditionnellement à la surface de tranches minces d'un matériau semi-conducteur, du silicium le plus souvent, dont une des faces a reçu un poli de qualité optique (poli miroir). Ceci notamment pour permettre une mise en œuvre optimale des techniques qui servent à définir, d'une façon toujours plus précise avec l'augmentation constante des niveaux d'intégration, tailles et formes des composants constituant ces circuits.

Toutefois, pour certains des dispositifs produits par l'industrie de la microélectronique, il peut être parfois très avantageux de les réaliser à la surface de substrats présentant un relief important ou une forte texturation. C'est le cas en particulier de dispositifs optoélectroniques tels que des diodes électroluminescentes ou des cellules photovoltaïques où une texturation de surface permet d'obtenir des caractéristiques optoélectroniques bien meilleures.

Par exemple, un procédé standard utilisé pour la production industrielle de cellules photovoltaïques utilise du silicium mono ou multi cristallin. Un substrat dopé, de type N ou P, doit tout d'abord subir une texturation de sa surface à l'aide d'une solution d'hydroxyde de potassium. La surface obtenue présente une structure pyramidale de taille micrométrique. Ceci afin de réduire sa réflectivité, d'augmenter la surface exposée aux faisceaux entrants et permettre l'obtention d'un meilleur confinement optique des faisceaux entrants dans le substrat.

Dans ce type de procédé destiné à produire des dispositifs à bas coût les métallisations finales qui servent aux interconnexions sont par ailleurs réalisées, après formation de toutes les couches formant un dispositif, par sérigraphie c'est-à-dire par impression à l'aide d'un pochoir d'une pâte métallique le plus souvent à base d'argent.

Du fait des reliefs de la surface texturée, il arrive souvent que lors du dépôt par sérigraphie de la pâte d'argent, cette dernière n'épouse pas bien la surface texturée du substrat. Le contact entre la pâte d'argent et le substrat peut être alors être interrompu en certains endroits. Le contact électrique est alors insatisfaisant.

Or la performance des dispositifs dépend étroitement de la qualité du contact électrique entre les métallisations et le substrat texturé.

Des solutions ont été apportées pour tenter de remédier à ce problème. Ainsi, des solutions prévoient une étape de recuit dans un four pour améliorer ce contact. Les conditions du recuit, notamment la température de celui-ci, sont déterminantes pour la qualité du contact électrique obtenu. Ces solutions ne sont pas toujours aisées à mettre en œuvre. Notamment, le choix de la température optimale du recuit peut être en pratique limitée par la présence de matériaux fragiles utilisés pour la fabrication de ces dispositifs. Par exemple, dans le cas des cellules photovoltaïques dites à hétérojonction, une couche de silicium amorphe est présente afin d'obtenir de meilleures caractéristiques optoélectroniques en limitant la recombinaison des porteurs. Cependant les métallisations doivent être alors être recuites à une température qualifiée de basse, c'est-à-dire inférieure à environ 400 C. Cette cuisson qui est nécessaire pour faire pénétrer le métal dans la structuration en silicium implique aussi l'utilisation de pâtes de sérigraphie spécifiques qui ne sont pas sans inconvénient, notamment : une résistance électrique plus élevée et une adhérence moindre sur le silicium en raison de la présence de nombreux d'additifs.

Le document US2010/0120191 décrit un dispositif photovoltaïque comprenant un substrat de silicium dont la face supérieure est dopée n et présente des reliefs, les reliefs définissant des sommets et des vallées. Un revêtement anti réfléchissant est déposé par pulvérisation de sorte à recouvrir les sommets des reliefs et à ne pas recouvrir les vallées. Le revêtement anti réfléchissant forme ainsi un masque laissant libre les vallées. Les vallées sont ensuite fortement dopées. Des points de contact en nickel sont ensuite déposés sur les vallées par un dépôt autocatalytique (electroless plating). Ce type de procédé s'avère en pratique complexe. Par ailleurs, ce type de procédé ne permet pas de définir des points ou des lignes métalliques de manière précise. En particulier, il ne permet pas de définir des lignes métalliques étroites et homogènes à la surface du substrat.

Il existe donc un besoin consistant à proposer une solution permettant d'améliorer le contact électrique entre les lignes et le substrat et de limiter la nécessiter d'utiliser des matériaux présentant une résistance électrique élevée ou une faible adhérence sur le substrat.

A cet effet, l'invention prévoit un procédé de réalisation de motifs métalliques sur une surface texturée d'une cellule photovoltaïque tel que défini dans la revendication indépendante 1.

Dans le cadre du développement de la présente invention, il s'est avéré que le procédé selon l'invention permet d'améliorer significativement la qualité du contact entre les lignes métalliques et le substrat et ce, sans pour autant détériorer la texture du substrat, ce qui était attendu en utilisant un procédé d'impression.

Le rendement du dispositif est par conséquent amélioré.

En outre, et de manière particulièrement avantageuse, le procédé selon l'invention permet de réaliser des motifs bien plus étroits qu'avec la technique connue de sérigraphie. La surface occupée par ces motifs peut donc être réduite. Il s'en suit une réduction de l'ombrage du substrat et une meilleure exposition de ce dernier au flux lumineux. Le rendement des dispositifs optoélectroniques tels que des panneaux photovoltaïques est ainsi substantiellement augmenté.

Enfin, le procédé selon l'invention permet de réaliser des motifs avec des métaux variés. Contrairement aux techniques connues de sérigraphie qui se limitent essentiellement à l'emploi de pâte d'argent, l'invention permet de réaliser des motifs dans des matériaux plus conducteurs tels que le cuivre par exemple.

Ainsi, l'invention permet d'une part d'améliorer la qualité du contact entre les motifs métalliques et le substrat et d'autre part de réduire l'ombrage de ce dernier sans pour autant avoir recours à des matériaux à forte résistance électrique.

Les performances des dispositifs obtenus selon l'invention sont par conséquence significativement améliorées.

De manière facultative, le procédé selon l'invention comprend en outre au moins l'une quelconque des caractéristiques optionnelles suivantes :
Les reliefs de la surface texturée présentent une amplitude supérieure à un dixième de fois la largeur minimale desdits motifs prise dans une direction parallèle au plan moyen du substrat. Le plus souvent, les reliefs de la surface texturée présentent une amplitude comprise entre un dixième de fois et mille fois la dimension minimale des motifs. Typiquement l'invention permet de métalliser des champs de nano-fils lorsque l'amplitude des reliefs est supérieure à cent fois la dimension minimale des motifs.

De manière générale, l'invention est particulièrement avantageuse lorsque les reliefs de la surface texturée présentent une amplitude supérieure à la moitié de la largeur minimale des motifs. L'invention est encore plus avantageuse lorsque la texture est encore plus prononcée et que les reliefs de la surface texturée présentent une amplitude supérieure à la largeur minimale des motifs. Typiquement, cette dimension minimale également désignée largeur minimale, est la largeur d'une ligne, d'une rainure ou d'une tranchée formée par le motif. La largeur de la ligne, de la rainure ou de la tranchée est sa dimension prise selon une direction perpendiculaire à la direction selon laquelle elle s'étend principalement.

De manière générale, la largeur minimale d'un motif est sa dimension minimale prise dans un plan perpendiculaire à la direction d'avancée du moule lors de l'étape de pressage. Cette largeur minimale est donc prise dans un plan sensiblement parallèle à celui de la surface du substrat. Elle est prise de préférence à la base du motif.

Lesdits reliefs de la surface texturée présentent une forme pyramidale et/ou une forme cylindrique de section circulaire et/ou polygonale et/ou forment des ondulations et/ou des rainures.

L'étape de préparation comprend une étape consistant à obtenir un substrat de base dont la surface est texturée et une étape de formation d'une couche de silicium amorphe recouvrant au moins partiellement ladite surface texturée. Avantageusement, cette étape permet d'obtenir des cellules photovoltaïques à hétérojonction.

L'étape de préparation comprend une étape consistant à doper un substrat de base avec des porteurs de charge de sorte à le rendre électriquement conducteur ou semi conducteur. De manière alternative et de préférence lorsque le substrat n'est pas conducteur ou n'est que faiblement conducteur, l'étape de préparation comprend une étape consistant à obtenir un substrat de base dont la surface est texturée et une étape de recouvrement de ladite surface texturée par une couche électriquement conductrice. Cette étape peut également être appliquée à un substrat dopé. Lorsqu'une couche de silicium amorphe a été disposée ou formée sur le substrat de base, par exemple pour la réalisation de cellules photovoltaïques à hétérojonction, la couche électriquement conductrice est disposée de sorte à recouvrir au moins en partie la couche de silicium amorphe. Ainsi, l'invention s'applique que le substrat de base soit conducteur, semi conducteur ou isolant.

De préférence, Le substrat est en silicium. Avantageusement il est en silicium monocristallin. Le substrat peut également être multi cristallin.

La couche électriquement conductrice est une couche d'oxyde d'indium dopé à l'étain (ITO).

Le matériau conducteur ou semi conducteur est un métal pris parmi l'aluminium, le cuivre, l'argent, le platine, le fer, l'or.

Après l'étape d'électrodéposition, on effectue une étape de recuit. Avantageusement, cette étape permet d'une part de modifier la cristallinité du dépôt de sorte à diminuer sa résistivité et d'autre part d'améliorer la conformité du dépôt du matériau conducteur ou semi conducteur. Ce dernier épouse alors bien les formes de la surface texturée. Les contacts sont donc de bonne qualité. Une bonne conformité du dépôt reflète un contact intime entre le matériau conducteur et le substrat. Elle traduit donc une interface présentant une résistivité peu élevée.

L'étape d'électrodéposition est effectuée de sorte que le matériau conducteur ou semi conducteur forme saillie au-delà des reliefs de la surface texturée. Les motifs réalisés s'étendent ainsi au-delà des reliefs. On obtient alors un sur-dépôt. Selon un mode particulier de réalisation, le sur-dépôt emplit totalement le motif imprimé dans le matériau imprimable et dépasse de ce dernier. Ainsi, le matériau conducteur ou semi conducteur forme saillie sur la surface libre du matériau imprimable. Avantageusement, cela permet de faciliter les interconnexions.

Le matériau imprimable est électriquement isolant.

L'étape d'électrodéposition est effectuée de sorte que les motifs en matériau conducteur ou semi conducteur forment saillie au-delà du matériau imprimable.

Le matériau imprimable est transparent et conservé après l'étape d'électrodéposition. Le matériau imprimable forme ainsi une couche de protection sans pour autant modifier les caractéristiques opto électroniques du dispositif.

Typiquement, le matériau imprimable est de type SOG (Spin On Glass). Il est par exemple à base de Phosphosilicates ou de Siloxanes ou de Silsesquioxane.

Le procédé comprend après l'étape d'électrodéposition une étape de retrait au moins partiel du matériau imprimable.

Le matériau imprimable est une résine photosensible, dans lequel le moule comprend un revêtement de masquage stoppant en partie au moins l'exposition de la résine qu'il recouvre sélectivement soit uniquement en dehors des motifs soit uniquement sur au moins un des motifs, et comprenant avant l'étape de retrait du moule une étape d'exposition pour activer la résine non masquée par le revêtement de masquage.

Dans un premier mode de réalisation la résine est une résine positive et le revêtement de masquage recouvre le moule en dehors de l'extrémité des motifs. Dans un deuxième mode de réalisation la résine est une résine négative et le revêtement de masquage recouvre le moule sur l'extrémité au moins des motifs.

Selon un mode de réalisation avantageux, lors de l'étape de couchage, le volume de la couche d'un matériau imprimable disposé sur ladite surface texturée est égal à $V_{couche}$, avec

$$V_{couche} = V_{Moule} + V_{Fill} + V_{sécurité}$$

avec :

$V_{moule}$ = le volume défini par les motifs du moule et qui sont destinés à être emplis de résine lors de l'étape de pressage.
$V_{Fill}$ = le volume libre entre la surface texturée et un plan qui est parallèle au substrat et qui passe par le point le plus haut du relief de plus grande amplitude.
$V_{sécurité}$ = (surface du substrat) x (épaisseur de sécurité). Distance entre le sommet du relief le plus haut et l'extrémité des motifs du moule.

De préférence, l'épaisseur de sécurité $e_s$ est définie de la manière suivante :

$$(e_s) \leq 2H_m - (A)$$

avec :

$H_m$ = hauteur des motifs du moule.
$A$ = amplitude maximale des reliefs. Cette distance est définie comme la différence entre la hauteur du relief le plus haut et le creux le plus bas de la surface texturée.

Selon un mode de réalisation avantageux, si le rapport de forme des reliefs de la surface texturée est supérieur ou égal à 3, alors la largeur des motifs du moule est supérieure à la largeur minimale des reliefs de la surface texturée. Cette condition permet de préserver la texturation de la surface texturée tout en définissant des motifs de faible largeur.

Si le rapport de forme des reliefs de la surface texturée est inférieur à 3, alors la largeur des motifs du moule peut être inférieure ou égale à la largeur minimale des reliefs de la surface texturée ou période de texturation.

Selon un autre aspect l'invention concerne un procédé de réalisation de plusieurs cellules photovoltaïques comprenant le procédé décrit précédemment.

Selon un autre aspect non revendiqué, on décrit un dispositif semi conducteur comportant un substrat comprenant une surface texturée présentant une pluralité de reliefs, l'amplitude de certains reliefs au moins étant supérieure ou égale à 100 nanomètres, le dispositif comprenant également des motifs formés dans un matériau conducteur ou semi conducteur et disposés sur la surface texturée du substrat. Au moins la surface texturée sous jacente auxdits motifs est électriquement conductrice et le dispositif comprend au moins un matériau transparent disposé entre les motifs.

De manière préférée, le substrat comprend un substrat de base recouvert d'une couche électriquement conductrice.

De manière préférée, les motifs formés dans un matériau conducteur ou semi conducteur forment des saillies au-delà dudit matériau transparent.

Selon un autre aspect non revendiqué, on décrit un dispositif semi conducteur comportant un substrat comprenant une surface texturée présentant une pluralité de reliefs, le dispositif comprenant également des motifs conducteurs ou semi conducteurs disposés sur la surface texturée du substrat, les motifs conducteurs ou semi conducteurs étant réalisés par l'un quelconque des procédés selon l'invention.

De préférence, le dispositif comprend entre les motifs des inter motifs formés dans la couche de matériau imprimable.

Avantageusement, le dispositif non revendiqué comprend une ou plusieurs cellules photovoltaïques. Selon un mode de réalisation particulier, la surface texturée du substrat de base comprend du silicium amorphe. Cette caractéristique est particulièrement avantageuse pour la réalisation de cellules photovoltaïques à hétérojonction.

BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :

La FIGURE 1 illustre différentes étapes d'un procédé selon un exemple.
La FIGURE 2 illustre un mode particulier de réalisation de l'une des étapes du procédé.

La FIGURE 3 illustre différentes étapes d'un procédé selon un exemple de réalisation de l'invention, le procédé étant adapté pour la production de cellules photovoltaïques à hétérojonction.

La FIGURE 4 illustre une façon de calculer la quantité de matériau imprimable qu'il est nécessaire de déposer sur le substrat avant impression.

La FIGURE 5 illustre un autre exemple avantageux pour déterminer la quantité de matériau imprimable à déposer sur le substrat avant impression.

Les dessins joints sont donnés à titre d'exemples et ne sont pas limitatifs de l'invention.

DESCRIPTION DÉTAILLÉE

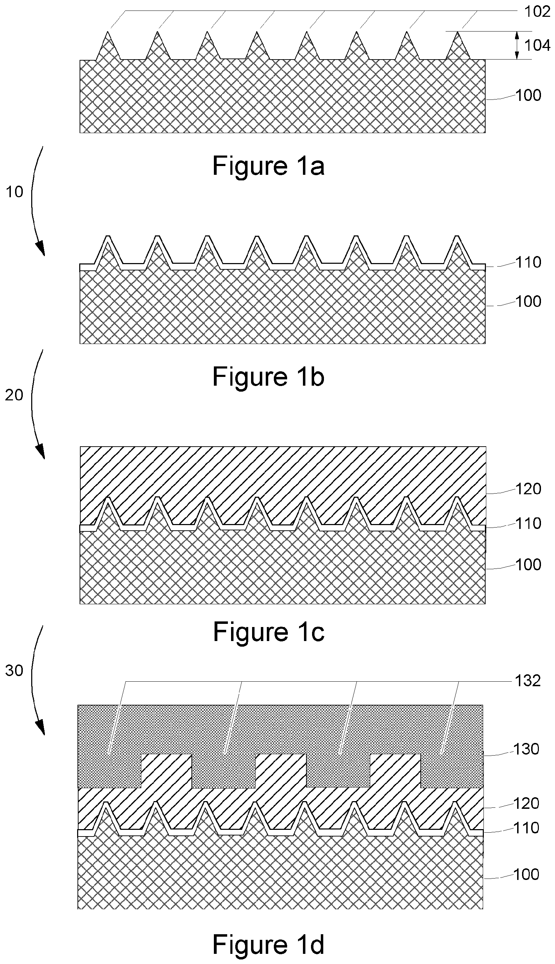

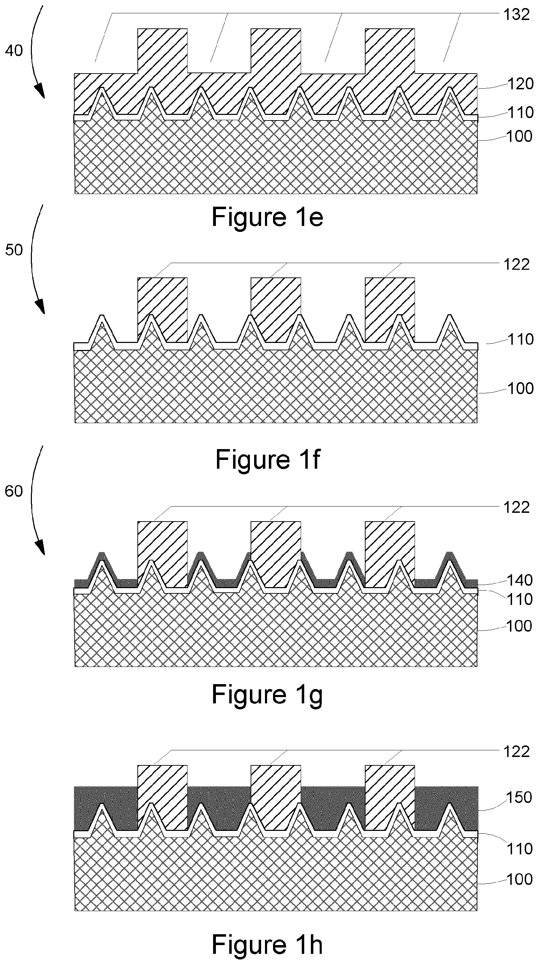

La figure 1, composée des figures 1a à 1h, décrit les étapes essentielles d'un procédé correspondant à un exemple nécessaire pour comprendre l'invention.

Cette première mise en œuvre ne fait pas référence à un type de dispositif particulier à produire. Elle décrit les étapes nécessaires à l'obtention de métallisations plus étroites que ce qu'il est possible d'obtenir sur un substrat par sérigraphie tout en assurant un bon contact électrique avec la surface texturée du substrat et en permettant l'utilisation de métaux qui sont de bien meilleurs conducteurs de l'électricité que les pâtes métalliques habituellement employées en sérigraphie. Typiquement les procédés connus de sérigraphie ne permettent pas d'obtenir des lignes métallisées dont l'épaisseur est inférieure à 80 microns (1 micron = 1 micromètre).

Comme montré sur la figure 1a, le substrat 100, le plus souvent du silicium, est texturé en surface. L'invention ne fait pas d'hypothèse sur la façon dont cette texturation est obtenue ni même si elle est produite intentionnellement. L'homme du métier sait cependant produire une texturation de surface pour améliorer des dispositifs notamment des dispositifs optoélectroniques. Des méthodes physico chimiques comme celle mentionnée dans le chapitre sur l'état de la technique sont connues. Dans le cas de silicium monocristallin une gravure humide anisotrope se pratique couramment pour la réalisation de systèmes électromécaniques de taille micrométrique connus sous leur acronyme de MEMS.

Pour réaliser des surfaces texturées présentant des reliefs de forme pyramidale on connaît par exemple les techniques suivantes:

- la réalisation de pyramides par attaque KOH pour hydroxyde de potassium ou TMAH pour hydroxyde de tétraméthyl amonium qui est sélective et permet la révélation des plans (1-1-1) du silicium et donc la formation des pyramides.
- la réalisation de structure dite «pyramide inversée » réalisée par attaque chimique après une étape de lithographie.

L'invention ne fait pas non plus d'hypothèse sur la géométrie de la texture produite. Elle est ici schématisée d'une façon arbitraire sous la forme de reliefs formant des pyramides 102, et donc présentant en coupe une section triangulaire, régulièrement espacées 102 sans que cela ne limite en rien l'application de l'invention à tout autre type de texturation.

Les reliefs 102 pourraient tout aussi bien présenter des formes de section polygonale ou circulaire selon un plan normal à la surface libre du substrat ou normal à cette même surface. Les reliefs 102 peuvent également présenter des formes courbes. Ils peuvent notamment être des ondulations de la surface du substrat.

En outre, l'espace entre deux motifs n'est pas nécessairement constant. Par ailleurs, les reliefs d'un même substrat peuvent présenter des formes variées.

D'une façon non limitative l'amplitude du relief 102 produit par la texturation sera typiquement comprise entre la centaine de nanomètres et plusieurs dizaines de microns (1 micron = $10^{-6}$ mètre) et plus particulièrement comprise entre 1 à 25 microns (1 micron = 1 micromètre) pour l'application. De manière générale l'amplitude d'un relief 102 est définie comme la distance entre son point le plus haut et son point le plus bas. Cette distance est prise selon une direction sensiblement normale à la surface du substrat. Plus particulièrement cette direction est normale au plan médian de la surface du substrat. Elle est généralement normale à la direction d'avancée du moule lors de l'étape de pressage. Sur les exemples illustrés cette direction est verticale et normale aux figures. Sur les exemples illustrés l'amplitude des reliefs, référencée 104, correspond à la distance entre la base et le sommet du triangle.

La taille de la base des reliefs est également comprise entre 3 et 25 microns (1 micron = 1 micromètre) et plus particulièrement entre 4 à 15 microns (1 micron = 1 micromètre). La taille de la base des reliefs correspond à la dimension maximale du relief prise au niveau de sa portion formant saillie par rapport à la surface du substrat prise entre deux reliefs.

Le pas d'une surface texturée correspond à la distance moyenne entre deux reliefs consécutifs. Par exemple, le pas de la surface texturée est compris entre de 2 et 20 microns (1 micron = 1 micromètre) et plus particulièrement comprise entre 4 à 15 microns (1 micron = 1 micromètre). Par exemple pour un pas de 9 $\mu$m des reliefs en forme de pyramide inversée font 6 $\mu$m de profondeur et pour un pas de 15 $\mu$m elles font 10 $\mu$m de profondeur. Typiquement, les pas sont mesurés entre deux sommets de pyramide. Comme on le verra ci-après le procédé selon l'invention a besoin que le substrat 100, 110 soit au moins en surface électriquement conducteur. La première étape 10 du procédé, étape optionnelle, dont le résultat est schématisé sur la figure 1b, consiste à déposer en surface d'un substrat de base 100, si nécessaire, une couche 110 d'un matériau électriquement conducteur. On obtient alors un substrat 100, 110 formé d'un substrat de base 100 et de la couche conductrice 110. La couche conductrice 110 épouse la forme du substrat de base et reproduit ainsi la texture du substrat de base 100.

Dans le cas de réalisation de dispositifs optoélectroniques il pourra devoir être aussi transparent. Un matériau tel que l'ITO (de l'anglais « indium tin oxide » c'est-à-dire : oxyde d'indium dopé à l'étain) pourra alors avantageusement être utilisé. Cette couche ne sera pas nécessaire si, par exemple, le substrat fait de silicium est suffisamment dopé pour être conducteur. Si le substrat de base 100 est isolant ou trop peu conducteur, la couche conductrice est alors nécessaire.

L'étape suivante 20 du procédé dont le résultat apparaît sur la figure 1c consiste à déposer une couche 120 d'un matériau tel qu'une résine, qui sera susceptible, comme on le verra à l'étape suivante, de recevoir une empreinte à partir d'un moule 130 du type de ceux utilisés dans la technique dite : lithographie par impression nanométrique, connue sous l'acronyme de NIL, de l'anglais « nano-imprint lithography ». Les deux techniques principales de lithographie par impression nanométrique sont brièvement rappelées ci-après. L'exemple nécessaire pour comprendre l'invention n'est pas limitatif concernant le type de matériau utilisé pour la couche 120 ni concernant les moyens de dépôt de celle-ci. Par exemple, s'il s'agit d'une résine liquide photosensible le dépôt pourra se faire simplement sur une tournette par centrifugation selon la technique connue sous son appellation anglaise de « spin-coating » et universellement utilisée par l'industrie de la microélectronique. Toutes les autres techniques de dépôt utilisées par cette industrie sont susceptibles d'être utilisées comme par exemple le dépôt sous vide, par évaporation thermique, etc.

La couche en matériau imprimable est un diélectrique. Elle n'est pas conductrice d'électricité.

Des matériaux connus sous leur appellation anglaise de « spin on glass » ou SOG pourront avantageusement être utilisés pour la couche 120. Il s'agit de matériaux diélectriques. Disponibles sous forme liquide ils peuvent aussi se déposer simplement par « spin-coating », comme la résine. Ces matériaux SOG se sont avérés particulièrement adaptés pour remplir la surface texturée quelle que soit la forme et l'amplitude des reliefs qui y ont été formés.

On pourra notamment utiliser des matériaux à base de Phosphosilicates ou de Siloxanes ou de Silsesquioxane par exemple. On peut par exemple utiliser un SOG de Dow Corning, Inc par exemple le HSQ pour hydrogène silesquioxane. La lithographie par impression nanométrique comprend deux techniques principales. La première, appelée T-NIL pour «thermal nanoimprint lithography», consiste à imprimer des monomères ou des polymères thermoplastiques chauffés, avec un moule opaque présentant des reliefs en creux et/ou en saillie. Après refroidissement le moule peut être enlevé, les motifs imprimés restent en place. La seconde technique, désignée par le signe P-NIL pour « photo-curable nanoimprint lithography » consiste à imprimer une résine photosensible avec un moule transparent présentant des reliefs en creux et/ou en saillie et à réaliser une insolation optique du film de résine au travers de celui-ci. L'insolation provoque la réticulation du film de résine qui se solidifie.

L'étape suivante 30 consiste donc à appliquer, comme montré sur la figure 1d, un moule 130 dans lequel sont gravés des reliefs de moule. Ces reliefs de moule correspondent aux motifs 132 de métallisation qu'il faut reproduire sur le dispositif en cours de fabrication. La pénétration du moule 130 dans la couche 120 imprime par pression les reliefs du moule 130 dans cette dernière.

Le retrait du moule 130 peut s'effectuer à l'étape 40 quand la couche 120 a été suffisamment solidifiée pour garder la forme des motifs 132. Le résultat est celui montré sur la figure 1e. Comme indiqué ci-dessus, suivant la nature du matériau déposé pour constituer la couche 120 et le type de moule employé, opaque ou transparent, la solidification peut mettre en œuvre des mécanismes très différents. On notera que dans le cas de l'utilisation d'un matériau initialement liquide, ou à tout le moins peu visqueux, comme une résine photosensible, le dépôt se fait aisément par centrifugation et la pression à exercer est faible ce qui peut être un avantage certain pour la mise en œuvre industrielle du procédé. En ce qui concerne le SOG mentionné précédemment qui se présente sous forme liquide il est solidifié à l'aide d'un recuit.

Quelle que soit la technique retenue par le procédé pour l'étape de lithographie par impression nanométrique, les motifs créés 132 ne sont souvent pas directement exploitables puisqu'il reste au fond des tranchées imprimées une partie du matériau qui a été utilisé pour former la couche 120. L'étape suivante 50, dont le résultat est montré sur la figure 1f, consiste en une attaque de la couche 120 jusqu'à mise à nu, au fond des tranchées, de la couche conductrice sous-jacente, c'est-à-dire la couche d'ITO 110 dans cet exemple. On peut pour cela réaliser par exemple une gravure dite RIE « reactive ion etching » en présence d'un plasma d'oxygène. Cette gravure est uniforme, la même quantité de matière est enlevée sur toute la surface. On arrête l'opération quand la résine située au niveau des zones imprimées est complètement gravée alors qu'il reste une épaisseur de résine suffisante sur les autres zones, correspondant aux zones situées entre les motifs à métalliser.

Une autre voie consiste en une attaque humide par voie chimique au cours de laquelle une épaisseur contrôlée de matériau est enlevée sur toute la surface.

Dans les deux cas on pourra privilégier les méthodes pour lesquelles il y a sélectivité de l'attaque de la couche conductrice 110 sous jacente, l'ITO dans cet exemple. C'est-à-dire les méthodes où l'attaque de la couche conductrice 110 sous jacente est beaucoup moins rapide que celle de la couche imprimable afin de faciliter la mise en œuvre industrielle de cette étape.

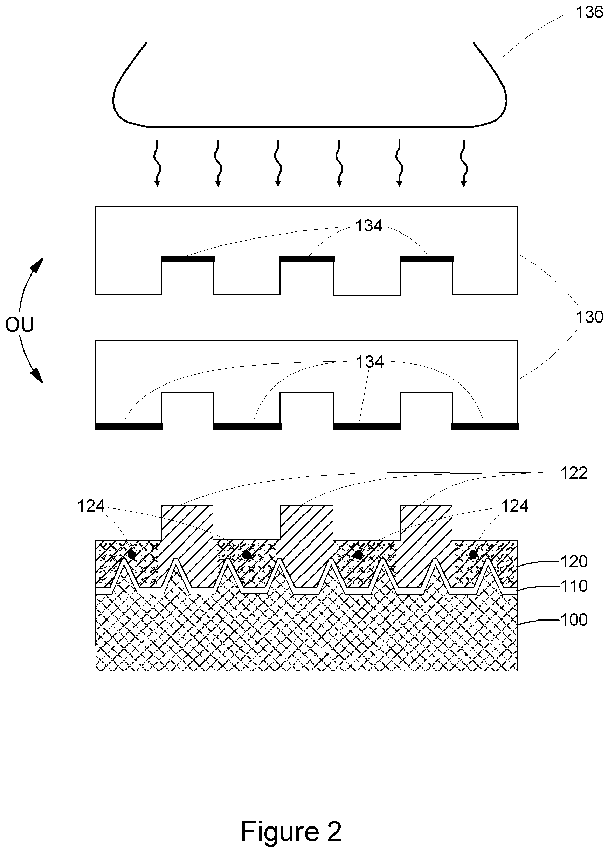

Dans tous les cas cela peut se faire sans déformation sensible des motifs imprimés. À la fin de l'étape 1f, il ne subsiste donc de la couche 120 que les inter motifs 122. Une méthode alternative est aussi décrite en figure 2.

Parvenu à ce stade on peut alors procéder à la métallisation des motifs. L'étape 60 consiste en une électrodéposition également appelée dépôt électrochimique d'un métal bon conducteur d'électricité sur la couche d'ITO 110 ou directement sur le substrat 100 s'il est lui-même un assez bon conducteur comme discuté précédemment.

L'électrodéposition est une opération couramment pratiquée par l'industrie chimique pour déposer des métaux sur des objets de toutes sortes. Elle se pratique en phase liquide dans un bac contenant un sel métallique en solution acide ou alcaline. Dans le cas qui nous intéresse c'est la tranche de semi-conducteur sur laquelle les dispositifs sont en cours de fabrication, et dont la structure correspond à la figure 1f, qui est complètement immergée dans le bain. La tranche est électriquement connectée au pôle négatif d'une source d'électricité. L'autre pôle est relié à une électrode, elle-même immergée et constituée par le métal à déposer ou bien une électrode inerte, par exemple en Platine, et de surface importante. Sous l'action du courant électrique, les ions métalliques contenu dans l'électrolyte se déposent sur la cathode c'est-à-dire sur la tranche aux endroits qui ne sont pas protégés par les inter motifs 122 pour former une couche métallique 140 comme montré sur la figure 1g. Une grande variété de métaux peut être déposée par cette technique en particulier, pour le type d'applications concerné où il faut une très bonne résistance de contact avec le substrat et une résistance série des interconnexions la plus faible possible, tous ceux qui sont de très bons conducteurs de l'électricité comme le cuivre, l'argent, l'or etc.

On peut également prévoir de déposer des matériaux semi-conducteurs comme par exemple des oxydes métalliques tel que Cu2O, semi-conducteur de type p ou ZnO, semi-conducteur de type n.

Pour toutes les caractéristiques du procédé selon l'exemple nécessaire pour comprendre l'invention et pour les dispositifs décrits, le métal déposé peut être remplacé par un matériau semi conducteur déposable par électro déposition.

La couche métallique 140 est dite conforme c'est-à-dire que la croissance se fait d'une façon égale dans toutes les directions sur le substrat texturé. Typiquement mais non limitativement, l'épaisseur de la couche est comprise entre quelques nanomètres à plusieurs dizaines de micromètres. Un sur-dépôt peut être pratiqué de façon à obtenir une couche épaisse 150 comme montrée sur la figure 1h afin de diminuer la résistance série des interconnexions.

On qualifie de sur-dépôt un dépôt de matériau conducteur ou semi conducteur effectué de sorte que ce matériau dépasse l'épaisseur de la résine. Le sur-dépôt est la continuation de l'électrodéposition.

La figure 2 décrit une mise en œuvre alternative de l'étape 50 du procédé qui consiste à la mise à nu, au fond des tranchées imprimées, de la couche sous-jacente.

Dans cette mise en œuvre alternative une résine photosensible est utilisée pour la couche en matériau imprimable 120. Le moule 130 est fait dans un matériau transparent. Cependant, il est fabriqué de telle façon que les reliefs en saillie ou en creux du moule sont rendus opaques selon que la résine utilisée est, respectivement, une résine positive ou une résine négative. Plus précisément, le moule 130 comprend un revêtement de masquage 134 stoppant en partie au moins l'exposition de la résine qu'il recouvre sélectivement soit uniquement en dehors des saillies du moule 130 soit uniquement sur au moins une des saillie du moule. Le procédé comprend alors, avant l'étape de retrait du moule, une étape d'exposition pour activer la résine non masquée par le revêtement de masquage 134.

Si la résine est une résine positive, alors le revêtement de masquage 134 recouvre le moule 130 en dehors de l'extrémité des saillies du moule 130. Si la résine est une résine négative, alors le revêtement de masquage 134 recouvre le moule 130 sur l'extrémité au moins des saillies tel qu'illustré sur la figure 2.

Ainsi, lorsque la couche 120 est insolée 136 à travers le moule 130 les parties comprimées 124 par les saillies du moule deviennent ou restent solubles selon que, respectivement, la résine est positive ou négative et qu'elle aura été effectivement insolée ou pas. Avantageusement, pour mettre à nu la couche sous-jacente 110 il suffit alors de dissoudre la résine dans les mêmes conditions que lors d'une opération de photolithographie classique. Comme précédemment seuls les inter motifs 122 restent en place pour permettre l'électrodéposition de métal qui suit comme indiqué en référence aux figures 1g et 1h.

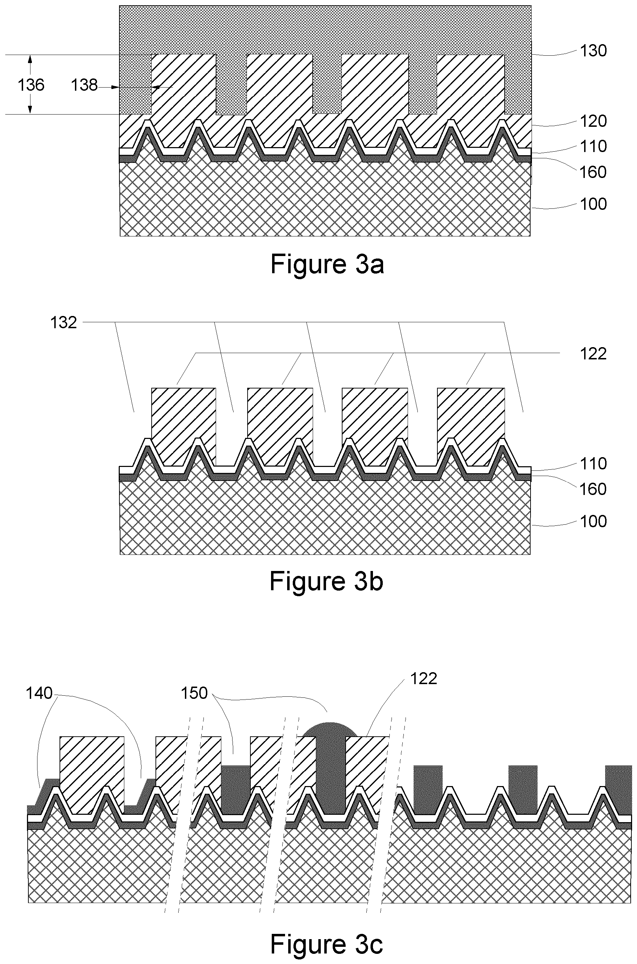

La figure 3 décrit plus particulièrement la mise en œuvre du procédé pour la production de cellules photovoltaïques à hétérojonction.

Comme discuté dans le chapitre sur l'état de la technique la métallisation des cellules photovoltaïques à hétérojonction est aujourd'hui réalisée par sérigraphie. Une pâte d'argent est déposée et étalée à travers un pochoir métallique appliqué sur la surface à métalliser. Le contact électrique entre la couche d'ITO et la métallisation n'est pas parfait. La sérigraphie ne permet de suivre qu'imparfaitement la rugosité du substrat. Pour améliorer le contact électrique entre cette métallisation argent et le substrat il faut, comme on l'a vu, pouvoir pratiquer un recuit qui n'endommage pas cependant les autres couches déjà déposées du dispositif et notamment le silicium amorphe utilisé par les cellules photovoltaïques.

Dans le cadre général d'une amélioration et d'une intégration toujours plus grande des dispositifs semi-conducteurs il est particulièrement important dans le cas des cellules photovoltaïques de pouvoir diminuer la largeur des métallisations tout en préservant, voire en diminuant, la résistance des contacts et des interconnexions. Un paramètre crucial pour les cellules photovoltaïques est en effet l'ombrage causé par les métallisations. Les zones ombrées ne participent pas à la production de courant et il faut donc pouvoir réduire leur surface tout en permettant que le courant généré puisse être transporté en sortie du dispositif sans pertes ohmiques significatives.

Le procédé décrit précédemment dans les figures 1a à 1h permet d'obtenir ce résultat. La figure 3a montre la structure d'un dispositif de type cellule photovoltaïque en cours de fabrication. La figure 3a est à comparer à la figure 1d où le moule 130 est appliqué pour imprimer la couche 120. La différence principale est la présence d'une couche de silicium amorphe 160 nécessaire pour la réalisation d'une hétérojonction avec le silicium du substrat 100 sous-jacent.

La figure 3b, qui est à comparer à la figure 1f, montre les inter motifs 122 qui restent en place après application de l'étape 50 du procédé où l'on vient enlever, au fond des tranchées imprimées, le matériau constituant la couche 120 qui a été compressé par le moule. L'une ou l'autre des méthodes décrites en figure 1 et 2 pourra être employée pour mettre à nu la couche sous jacente d'ITO 110 au fond des tranchées 132.

La figure 3c montre les différents résultats qu'il est possible d'obtenir après l'étape d'électrodéposition 60. On peut ainsi obtenir un dépôt métallique d'épaisseur de quelques couches monoatomiques conforme qui épouse la texture de surface 140. Un dépôt plus important permet de remplir partiellement ou complètement les cavités formées par l'impression nanométrique dans la résine. Un sur-dépôt en forme de « champignon » peut être obtenu en prolongeant l'électrodépôt ; ainsi la prise de contact est facilitée puisque la surface du contact est plus importante. Différents niveaux de sur-dépôts peuvent aussi être obtenus 150. On notera aussi que les inter motifs 122 peuvent ou non rester en place. Notamment, l'utilisation pour la couche 120 d'un matériau tel que le SOG mentionné précédemment, qui reste transparent après solidification effectuée à l'aide d'un recuit, peut aussi servir de protection au dispositif auquel cas il n'est pas enlevé après métallisation.

Le procédé selon l'invention permet de former des motifs très étroits, typiquement jusqu'à 10 nanomètres. A titre d'exemple, il permet aisément de former des lignes métalliques de 10 micromètres de largeur pour les reliefs dont les dimensions ont été données ci-dessus, le contact entre ces lignes et le substrat étant de très bonne qualité.

De manière générale, l'invention permet avantageusement de réaliser des motifs dont la largeur est comprise entre 10 nm et 100 $\mu$m quel que soit le rapport de forme des reliefs sur la surface par rapport au rapport de forme des motifs à réaliser par impression.

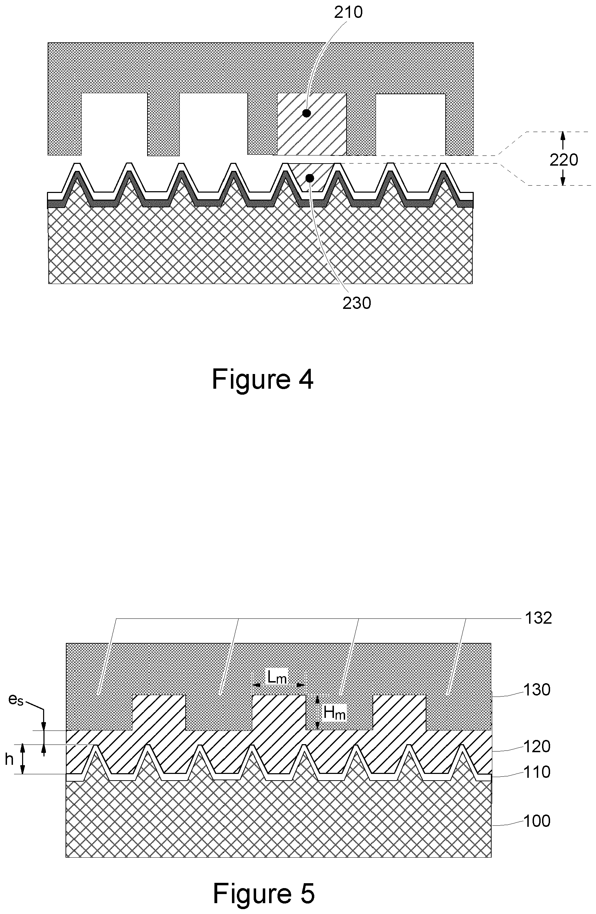

La figure 4 illustre la façon de calculer la quantité de résine ou de matériau qu'il est nécessaire de déposer sur le substrat avant impression.

Il faut déposer sur la plaque en cours de fabrication une quantité de résine, ou de matériau constituant la couche à imprimer, suffisante pour remplir après pressage tous les creux du moule et toutes les rainures et, en général, toutes les anfractuosités créées par la texturation en surface du substrat. Par ailleurs, on veut pouvoir maintenir après pressage du moule une épaisseur minimale 220 entre les sommets des motifs du moule et ceux des aspérités du substrat. Typiquement, cette épaisseur minimale sera de seulement quelques dizaines de nanomètres (nm = $10^{-9}$ mètre).

La quantité de matériau à déposer pourra facilement se calculer en fonction, d'une part, de la géométrie des motifs du moule et de leur hauteur, et d'autre part du volume des anfractuosités qu'il faut pouvoir remplir plus la mince couche qu'il faut maintenir entre sommets du moule et aspérités du substrat. Le volume des anfractuosités pourra se calculer aisément si la texturation correspond à des formes géométriques simples comme celle utilisée dans les figures servant à illustrer l'invention ou alors s'estimer expérimentalement à partir d'un substrat texturé.

La hauteur minimale des motifs du moule est directement fonction du rapport de forme que l'on désire obtenir pour les interconnexions comme illustré sur la figure 3c. La largeur des motifs prise selon une direction sensiblement normale à la direction d'application du moule peut varier typiquement de 20nm à plusieurs micromètres. Leur espacement peut varier dans une gamme de 100nm à plusieurs centaines de micromètres.

La pression d'application du moule dépend essentiellement de la technique et du matériau utilisé pour la couche 120. L'utilisation de matériaux liquide ou faiblement visqueux tel les résines photos sensibles où la solidification s'effectue par insolation (P-NIL) ou par recuit (SOG) autorise une pression faible de l'ordre de 1 à 2 bars. L'impression se fait alors à température ambiante. Les résines photo sensibles sont polymérisables ou réticulables. Il s'agit par exemple de résines de type époxy, vinylique, acrylate et méthacrylate.

Des pressions comprises entre 2 et 15 bars pourront être nécessaires s'il faut chauffer le matériau à imprimer (T-NIL). Ce paramètre dépendra fortement du temps d'impression que l'on cherche à obtenir et de la température atteinte par le matériau à imprimer et donc de sa viscosité au moment de l'impression. En augmentant la température d'impression on diminue la viscosité du matériau et on peut donc aussi réduire la pression appliquée et/ou le temps d'impression. La température d'impression est fonction du matériau choisi. Pour un matériau thermoplastique, par exemple pour une résine type PMMA (Polymethylmethacrylate), polystyrène, polycarbonate ou polyoléfine, il faut se placer au-delà de la température de transition vitreuse. Pour un matériau thermodurcissable, par exemple pour une résine époxy ou polyéther, l'impression est réalisée à une température inférieure à la température de durcissement. Le démoulage est alors réalisé en portant la température au-delà de la température de durcissement et après stabilisation du matériau.

Par ailleurs, le contrôle du dépôt et de la croissance de la couche métallique au cours de l'étape d'électrodéposition 60 met en œuvre de nombreux paramètres et mécanismes physicochimiques dont certains sont discutés ci-après :

- Connaissant la surface totale du substrat, incluant l'effet de la texturation de cette dernière, et en supposant dans un premier temps que le rendement de la réaction d'électrodéposition est proche de 100%, la loi de Faraday, rappelée ci-dessous, permet de déterminer le nombre de moles déposées. On peut alors estimer, en fonction du courant appliqué, le temps nécessaire pour obtenir l'épaisseur désirée de métal.

$$\frac{It}{nF}M = m$$

Avec $I$ : la valeur du courant, $t$ : le temps, $n$ : le nombre d'électrons échangés dans la réaction d'oxydoréduction, $F$ : le nombre de Faraday, $M$ : la masse molaire du matériau déposé et m : le nombre de moles déposées.

- Dans le cas où le rendement de réaction est inférieur à 100%, une ou plusieurs réactions parasites peuvent avoir lieu au détriment de la réaction de dépôt principale. Une des réactions parasites les plus courantes en milieu acide est la réduction des ions H+ en hydrogène. En fonction des constituants de l'électrolyte on peut réduire d'autres cations que les cations métalliques à déposer. Le dépôt à potentiel imposé peut permettre de pallier ce problème. En effet, le dépôt à potentiel imposé permet de fixer ce potentiel à une valeur à laquelle se fait la réaction d'intérêt. Ainsi on limite les risques qu'une réaction parasite survienne. D'autre part, cela permet aussi de mieux contrôler les mécanismes de nucléation du dépôt. Connaissant le nombre de charges électriques exprimées en coulombs qui traversent le système au potentiel de dépôt choisi, et considérant le dépôt conforme, on peut facilement estimer l'épaisseur déposée et réaliser des sur-dépôts.

De plus il existe deux types de nucléation et trois modes de croissance rappelés ci-après :

- la nucléation instantanée : tous les sites commencent à croître en même temps.
- la nucléation progressive : il y a progressivement de plus en plus de germination dans les sites.
- croissance de type Franck Van Der Merwe, ou croissance couche par couche. Il s'agit d'un cas idéal assez peu observé. Le dépôt est uniforme, une nouvelle couche ne se forme que lorsque la précédente est remplie. Ce type de croissance ne se produit que sur des surfaces sans défauts, la croissance est bidimensionnelle. Dans le cas des cellules photovoltaïques où le matériau n'est pas de grande qualité, de nombreux défauts de surface rendent ce mode peu probable.

- croissance de type Stranski-Krastanov. Il y a formation de sous-couches dans un premier temps, puis croissance de clusters. Ce phénomène intervient dans le cas d'une surface présentant des défauts, la croissance est alors tridimensionnelle.
- croissance de type Volner-Weber. Dans ce cas les clusters se forment directement à la surface du métal, sans présence de sous-couches.

En fonction du mode de germination et de croissance le dépôt sera donc plus ou moins conforme. Dans le cas d'une croissance de type Stranski-Krastanov ou Volner-Weber, le dépôt présentera des clusters. Une croissance limitée par la diffusion de matière donnera lieu à la formation d'un dépôt dendritique (croissance sous forme d'arbres, de dendrites) qui est par définition non conforme.

Le choix de la technique de dépôt peut largement influencer les modes de germination et de croissance. Ainsi, pour favoriser un grand nombre de nucléis, le régime pulsé est particulièrement approprié. Ce type de régime consiste à alterner des impulsions, en courant ou en potentiel, cathodiques de réduction à des impulsions anodiques ou au potentiel d'abandon. Plus le nombre de nucléis est important et plus le dépôt sera conforme. De manière générale, un potentiel d'abandon est le potentiel que prend une électrode lorsqu'elle est mise en contact avec un électrolyte. On peut l'associer au potentiel d'équilibre de l'électrode. Une impulsion cathodique est une impulsion en courant ou en potentiel qui génère une réduction. Si l'on travaille en potentiel, cela correspond à un potentiel inférieur au potentiel d'équilibre. Une impulsion anodique est une impulsion en courant ou en potentiel qui génère une oxydation. Si l'on travaille en potentiel, cela correspond à un potentiel supérieur au potentiel d'équilibre.

Dans le cas défavorable où les diverses méthodes électrochimiques ne permettent pas d'obtenir un dépôt suffisamment conforme pour l'application, un recuit approprié permettra de densifier le dépôt et d'améliorer l'interface dépôt/substrat. Le contact intime avec le substrat sera alors plus intime et l'interface sera peu résistive. On notera également que l'ajout d'additifs dans le bain de dépôt peut aider à rendre le dépôt conforme.

Un sur-dépôt peut également être envisagé pour améliorer la conduction électrique de la structure et réaliser des plots de contacts de taille plus importante que l'interface métal/substrat comme montré sur la figure 3c.

En figure 5, plusieurs dimensions sont référencées. Ces dimensions permettent de calculer l'épaisseur à déposer pour ne pas endommager les reliefs de la surface texturée tout en obtenant des motifs de faible dimension par nanoimpression.

Selon un mode de réalisation avantageux, lors de l'étape de couchage, le volume $V_{couche}$ de la couche d'un matériau imprimable disposé sur ladite surface texturée est égal à :

$$V_{couche} = V_{Moule} + V_{Fill} + V_{sécurité}$$

avec :

$V_{moule}$ = le volume défini par les motifs du moule. Sur la figure 5, le volume $V_{moule}$ est égal à la somme des volumes individuels définis par les largeurs Lm, les hauteurs Hm et les profondeurs (non représentées) de ces motifs.

$V_{Fill}$ = le volume libre entre la surface texturée et un plan qui est parallèle au substrat et qui passe par le point le plus haut du relief de plus grande amplitude. Typiquement, ce plan est perpendiculaire au plan de la section représentée sur la figure 5. En pratique, si le substrat présente une forme de plaque avec deux faces opposées, le plan est parallèle à ces faces. Typiquement, ce volume est déterminé par analyse de la surface occupée par les reliefs de la surface texturée sur une image du substrat prise par microscope à force atomique (AFM).

La surface du substrat est l'aire de la surface macroscopique. Autrement dit, il s'agit de l'aire de chacune des faces de la plaque que forme le substrat.

$V_{sécurité}$ = (surface du substrat) x (épaisseur de sécurité). L'épaisseur de sécurité est représenté par la référence $e_s$ sur la figure 5. Elle correspond à la référence 220 sur la figure 4. Elle correspond à une épaisseur de résine minimale entre les sommets des motifs du moule et les sommets des reliefs de la surface texturée. Typiquement, le minimum de cette épaisseur de sécurité est de quelques dizaines de nanomètres (nm = 10⁻⁹ mètre).

De manière particulièrement avantageuse, l'épaisseur de sécurité $e_s$ est définie de la manière suivante : $(e_s) \leq 2H_m - (A)$ :
avec :

$H_m$ = hauteur des motifs du moule. Sur la figure 5 la largeur des motifs du moule est référencée $H_m$.
A = amplitude maximale des reliefs. Cette distance est définie comme la différence de hauteur entre le sommet du relief le plus haut et le creux le plus bas de la surface texturée. Cette amplitude est également désignée « pic à vallée » ou en anglais « pic to valley » du relief le plus haut. Au microscope AFM, on définit aisément le relief le plus haut de la surface texturée, le creux le plus base de la surface texturée et on détermine aisément leur différence de hauteur.

Sur la figure 5, cette amplitude maximale est référencée 'h'.

En outre avantageusement, $H_m \geq (A)$

Avantageusement, le respect de ces conditions permet d'obtenir un transfert de très bonne qualité pour les motifs du moule et sans endommager les reliefs de la surface texturée.

Selon un mode de réalisation avantageux, si le rapport de forme des reliefs de la surface texturée est supérieur ou égal à 3, alors la largeur des motifs du moule est supérieure à la largeur minimale des reliefs de la surface texturée.

Cette condition permet de préserver la texturation de la surface texturée tout en définissant des motifs de faible largeur. Sur la figure 5, la largeur des reliefs est la largeur de la base d'un relief formant un triangle dans la couche 100 ou dans la couche 110.

On appelle rapport de forme de la surface texturée le rapport 'h'/'l', dans lequel 'h' est la hauteur des reliefs et 'l' la largeur des reliefs. Sur la figure 5 la largeur des motifs du moule est référencée $L_m$.

De préférence, si le rapport de forme des reliefs de la surface texturée est inférieur à 3, alors la largeur des motifs du moule peut être inférieure ou égale à la largeur minimale des reliefs de la surface texturée ou période de texturation.

En résumé l'invention décrit un procédé pour réaliser par électrodéposition des lignes ou motifs métalliques de taille submicronique sur une surface texturée d'une cellule photovoltaïque présentant une rugosité micrométrique ou une forte texturation. Le dépôt électrochimique se fait à travers un masque dur obtenu par impression d'un moule.

-　Le dépôt électrochimique permet de réaliser des dépôts conformes et d'obtenir un contact électrique de qualité sur des surfaces présentant une forte rugosité ou texturation.
-　L'impression des motifs à partir d'un moule permet d'obtenir de bonnes résolutions avec des profondeurs de champ élevées en dépit d'une forte structuration du substrat.

Le procédé de l'invention s'applique à la fabrication de cellules photovoltaïques. Il permet de réaliser les contacts électriques et interconnexions avec un métal pur autre que les pâtes d'argent classiquement utilisées en sérigraphie. Cela permet d'améliorer la conductivité électrique des métallisations et d'en diminuer les dimensions sans réduire, voire en les améliorant, les performances des dispositifs fabriqués. En outre la dimension réduite des motifs métallisés permet de réduire l'ombrage du substrat ce qui contribue également à améliorer le rendement des dispositifs.

Par ailleurs, l'invention permet d'obtenir un bon contact entre les motifs métallisés et le substrat même lorsque la surface destinée à recevoir lesdits motifs présente des défauts de surface importants tels que :

- la présence de joints de grains créant en surface des marches dues à des hauteurs de grains différents,
- des ondulations de surface apparaissant lors de la découpe des plaques, par exemple à la scie,
- les plaques peuvent être biseautées.

Ces défauts s'observent particulièrement fréquemment lors de l'utilisation de substrats multi cristallins. Or, ces substrats, bien moins chers que des substrats de silicium monocristallin, tendent à être massivement utilisés, en particulier dans le domaine du photovoltaïque. Ainsi, l'invention, en permettant de déposer correctement des motifs métalliques sur ces substrats multi cristallins, présente des avantages indéniables en terme industriel et économique.

**Revendications**

1. Procédé de réalisation de motifs conducteurs ou semi-conducteurs d'électricité sur une surface texturée d'une cellule photovoltaïque, la texturation de la surface texturée présentant une pluralité de reliefs (102) dont l'amplitude est supérieure ou égale à 100 nanomètres, le procédé comprenant les étapes suivantes :

   - une étape de préparation (10) d'un substrat (100, 110) au cours de laquelle toute ladite surface texturée du substrat est rendue électriquement conductrice ;
   - une étape de couchage (20) au cours de laquelle on dispose sur ladite surface texturée rendue électriquement conductrice au moins une couche d'un matériau imprimable (120);
   - une étape de pressage (30) d'un moule (130) comportant des creux ou des saillies de sorte à transférer les creux ou les saillies du moule (130) dans le matériau imprimable (120) pour y former des motifs (132);
   - une étape de retrait (40) du moule laissant apparaître les motifs (132) dans le matériau imprimable (120) ;
   - une étape de mise à nu (50), au fond des motifs, de ladite surface texturée;
   - une étape d'électrodéposition (60) d'au moins un matériau conducteur ou semi-conducteur d'électricité dans les motifs (132) pour former des motifs conducteurs ou semi-conducteurs (140, 150) à partir de ladite surface texturée du substrat rendue électriquement conductrice.

2. Procédé selon la revendication précédente dans lequel lesdits reliefs (102) de ladite surface texturée présentent une amplitude supérieure à un dixième de fois la largeur minimale desdits motifs (132).

3. Procédé selon la revendication précédente dans lequel lesdits reliefs (102) de ladite surface texturée présentent une amplitude supérieure à la largeur minimale desdits motifs (132) et dans lequel les motifs ont une largeur de préférence comprise entre 10 nm et 100 $\mu$m.

4. Procédé selon l'une quelconque des revendications précédentes dans lequel lesdits reliefs (102) de la surface texturée présentent une forme pyramidale inversée ou non inversée et/ou une forme cylindrique de section circulaire inversée ou non inversée et/ou polygonale inversée ou non inversée et/ou forment des ondulations et/ou des rainures.

5. Procédé selon l'une quelconque des revendications précédentes dans lequel l'étape de préparation (10) comprend une étape consistant à obtenir un substrat de base (100) dont la surface est texturée et une étape de formation d'une couche (160) de silicium amorphe recouvrant au moins partiellement ladite surface texturée.

6. Procédé selon l'une quelconque des revendications précédentes dans lequel l'étape de préparation (10) comprend une étape consistant à doper un substrat de base (100) avec des porteurs de charge de sorte à le rendre électriquement conducteur ou semi conducteur.

7. Procédé selon l'une quelconque des revendications précédentes dans lequel l'étape de préparation (10) comprend une étape consistant à obtenir un substrat de base (100) dont la surface est texturée et une étape de recouvrement au moins partiel de ladite surface texturée par une couche électriquement conductrice (110) et dans lequel la couche électriquement conductrice (110) est de préférence une couche d'oxyde d'indium dopé à l'étain (ITO).

8. Procédé selon l'une quelconque des revendications précédentes dans lequel après l'étape d'électrodéposition (60) on effectue une étape de recuit.

9. Procédé selon l'une quelconque des revendications précédentes dans lequel l'étape d'électrodéposition (60) est effectuée de sorte que les motifs (150) conducteurs ou semi conducteurs forment saillie au-delà du matériau imprimable (120) ou est effectuée de sorte que le matériau conducteur ou semi conducteur forme saillie au-delà des reliefs (102) de la surface texturée.

10. Procédé selon l'une quelconque des revendications précédentes dans lequel le matériau imprimable est transparent et dans lequel le matériau imprimable (120) est conservé après l'étape d'électrodéposition (60).

**11.** Procédé selon l'une quelconque des revendications 1 à 9 comprenant après l'étape d'électrodéposition une étape de retrait au moins partiel du matériau imprimable.

**12.** Procédé selon l'une quelconque des revendications précédentes dans lequel le matériau imprimable (120) est une résine photosensible, dans lequel le moule (130) comprend un revêtement de masquage (134) stoppant en partie au moins l'exposition de la résine qu'il recouvre sélectivement soit uniquement en dehors des motifs soit uniquement sur au moins un des motifs, et comprenant avant l'étape de retrait du moule (130) une étape d'exposition pour activer la résine non masquée par le revêtement de masquage (134) et dans lequel la résine est une résine positive et le revêtement de masquage (134) recouvre le moule (130) en dehors de l'extrémité des motifs ou dans lequel la résine est une résine négative et le revêtement de masquage (134) recouvre le moule (130) sur l'extrémité au moins des motifs.

**13.** Procédé selon l'une quelconque des revendications précédentes dans lequel lors de l'étape de couchage, le volume de la couche d'un matériau imprimable (120) disposé sur ladite surface texturée est égal à $V_{couche}$, avec

$$V_{couche} = V_{Moule} + V_{Fill} + V_{sec\,urité}$$

avec :

> $V_{moule}$ = le volume défini par les motifs du moule,
> $V_{Fill}$ = le volume libre entre la surface texturée et un plan qui est parallèle au substrat et qui passe par le point le plus haut du relief de plus grande amplitude,
> $V_{sécurité}$ = (surface du substrat) x (épaisseur de sécurité), l'épaisseur de sécurité (220, $e_s$) étant la distance entre le sommet du relief le plus haut de la surface texturée et l'extrémité des motifs du moule,

et dans lequel l'épaisseur de sécurité $e_s$ est définie de la manière suivante :

$$(e_s) \leq 2H_m - (A)$$

avec :

> A = distance entre le point le plus haut et le point le plus bas de la surface texturée,
> $H_m$ = hauteur des motifs du moule.

**14.** Procédé selon l'une quelconque des revendications précédentes dans lequel si le rapport des forme des reliefs de la surface texturée est supérieur ou égal à 3, alors défini le moule de sorte que la largeur des motifs du moule est supérieure à la largeur minimale des reliefs de la surface texturée.

**15.** Procédé de réalisation de plusieurs cellules photovoltaïques comprenant un procédé selon l'une quelconque des revendications précédentes.

**Patentansprüche**

**1.** Verfahren zur Herstellung von Elektrizität leitenden oder halbleitenden Mustern auf einer texturierten Oberfläche einer Photovoltaikzelle, wobei die Texturierung der texturierten Oberfläche eine Vielzahl von Erhebungen (102) aufweist, deren Amplitude größer oder gleich 100 Nanometer ist, wobei das Verfahren die folgenden Schritte umfasst:

> - einen Schritt des Vorbereitens (10) eines Substrats (100, 110), in dessen Verlauf die gesamte texturierte Oberfläche des Substrats elektrisch leitend gemacht wird;
> - einen Beschichtungsschritt (20), in dessen Verlauf mindestens eine Schicht eines druckbaren Materials (120) auf der elektrisch leitend gemachten texturierten Oberfläche angeordnet wird;
> - einen Schritt des Aufpressens (30) einer Form (130), die Vertiefungen oder Vorsprünge umfasst, um die Vertiefungen oder die Vorsprünge der Form (130) in das druckbare Material (120) zu übertragen, um darin Muster (132) zu bilden;
> - einen Schritt des Entfernens (40) der Form, der die Muster (132) im druckbaren Material (120) erscheinen lässt;
> - einen Schritt des Freilegens (50) der texturierten Oberfläche am Boden der Muster;
> - einen Schritt der Elektroabscheidung (60) mindestens eines Elektrizität leitenden oder halbleitenden Materials in den Mustern (132), um auf Grundlage der texturierten Oberfläche des elektrisch leitend gemachten Substrats leitende oder halbleitende Muster (140, 150) zu bilden.

**2.** Verfahren nach dem vorstehenden Anspruch, wobei die Erhebungen (102) der texturierten Oberfläche eine Amplitude von größer als einem Zehntel der minimalen Breite der Muster (132) aufweisen.

**3.** Verfahren nach dem vorstehenden Anspruch, wobei die Erhebungen (102) der texturierten Oberfläche eine Amplitude von größer als der minimalen Breite der Muster (132) aufweisen, und wobei die Muster eine Breite von bevorzugt im Bereich zwischen 10 nm und 100 $\mu$m aufweisen.

4. Verfahren nach einem der vorstehenden Ansprüche, wobei die Erhebungen (102) der texturierten Oberfläche eine umgekehrte oder nicht umgekehrte Pyramidenform und/oder eine umgekehrte oder nicht umgekehrte Zylinderform von kreisrundem Querschnitt und/oder umgekehrte oder nicht umgekehrte polygonale Zylinderform aufweisen und/oder Wellen und/oder Rillen bilden.

5. Verfahren nach einem der vorstehenden Ansprüche, wobei der Vorbereitungsschritt (10) einen Schritt umfasst, der darin besteht, ein Basissubstrat (100) zu erhalten, dessen Oberfläche texturiert ist, und einen Schritt des Bildens einer Schicht (160) aus amorphem Silizium, die die texturierte Oberfläche mindestens teilweise bedeckt.

6. Verfahren nach einem der vorstehenden Ansprüche, wobei der Vorbereitungsschritt (10) einen Schritt umfasst, der darin besteht, ein Basissubstrat (100) mit Ladungsträgern zu dotieren, um dasselbe elektrisch leitend oder halbleitend zu machen.

7. Verfahren nach einem der vorstehenden Ansprüche, wobei der Vorbereitungsschritt (10) einen Schritt umfasst, der darin besteht, ein Basissubstrat (100) zu erhalten, dessen Oberfläche texturiert ist, und einen Schritt des mindestens teilweisen Bedeckens der texturierten Oberfläche mit einer elektrisch leitenden Schicht (110), und wobei die elektrisch leitende Schicht (110) bevorzugt eine zinndotierte Indiumoxidschicht (ITO) ist.

8. Verfahren nach einem der vorstehenden Ansprüche, wobei nach dem Schritt der Elektroabscheidung (60) ein Schritt des Glühens vorgenommen wird.

9. Verfahren nach einem der vorstehenden Ansprüche, wobei der Schritt der Elektroabscheidung (60) so vorgenommen wird, dass die leitenden oder halbleitenden Muster (150) einen Vorsprung über das druckbare Material (120) hinaus bilden, oder so vorgenommen wird, dass das leitende oder halbleitende Material einen Vorsprung über die Erhebungen (102) der texturierten Oberfläche hinaus bildet.

10. Verfahren nach einem der vorstehenden Ansprüche, wobei das druckbare Material transparent ist, und wobei das druckbare Material (120) nach dem Schritt der Elektroabscheidung (60) belassen wird.

11. Verfahren nach einem der Ansprüche 1 bis 9, das nach dem Schritt der Elektroabscheidung einen Schritt des mindestens teilweisen Entfernens des druckbaren Materials umfasst.

12. Verfahren nach einem der vorstehenden Ansprüche, wobei das druckbare Material (120) ein Fotolack ist, wobei die Form (130) einen Maskierüberzug (134) umfasst, der die Belichtung des Lacks, den er selektiv entweder nur außerhalb der Muster oder nur auf mindestens einem der Muster bedeckt, mindestens zum Teil stoppt, und vor dem Schritt des Entfernens der Form (130) einen Belichtungsschritt umfassend, um den nicht vom Maskierüberzug (134) maskierten Lack zu aktivieren, und wobei der Lack ein Positivlack ist und der Maskierüberzug (134) die Form (130) außerhalb des Endes der Muster bedeckt, oder wobei der Lack ein Negativlack ist und der Maskierüberzug (134) die Form (130) mindestens am Ende der Muster bedeckt.

13. Verfahren nach einem der vorstehenden Ansprüche, wobei beim Schritt des Beschichtens das Volumen der Schicht aus einem druckbaren Material (120), das auf der texturierten Oberfläche angeordnet wird, gleich $V_{Schicht}$ ist, wobei

$$V_{Schicht} = V_{Form} + V_{Füll} + V_{Sicherheit}$$

wobei:

$V_{Form}$ = das von den Mustern der Form definierte Volumen,
$V_{Füll}$ = das freie Volumen zwischen der texturierten Oberfläche und einer Ebene, die zum Substrat parallel ist und die durch den höchsten Punkt der Erhebung mit der größten Amplitude verläuft,
$V_{Sicherheit}$ = (Oberfläche des Substrats) x (Sicherheitsdicke), wobei die Sicherheitsdicke (220, $e_s$) der Abstand zwischen der Spitze der höchsten Erhebung der texturierten Oberfläche und dem Ende der Muster der Form ist,

und wobei die Sicherheitsdicke $e_s$ wie folgt definiert ist:

$$\left(e_s\right) \le 2H_m - \left(A\right)$$

wobei:

A = Abstand zwischen dem höchsten Punkt und dem tiefsten Punkt der texturierten Oberfläche,
$H_m$ = Höhe der Muster der Form.

14. Verfahren nach einem der vorstehenden Ansprüche, wobei wenn das Verhältnis der Formen der Erhebungen der texturierten Oberfläche größer oder gleich 3 ist, dann die Form so definiert ist, dass die Breite der Muster der Form größer ist als die minimale Breite der Erhebungen der texturierten Oberfläche.

**15.** Verfahren zur Herstellung mehrerer Photovoltaikzellen, das ein Verfahren nach einem der vorstehenden Ansprüche umfasst.

## Claims

**1.** Method for producing patterns which are conductors or semi-conductors of electricity on a textured surface of a photovoltaic cell, the texturizing of the textured surface having a plurality of reliefs (102) of which the amplitude is greater than or equal to 100 nanometres, the method comprising the following steps:

- a step of preparing (10) a substrate (100, 110) during which the whole of said textured surface of the substrate is made electrically conductive;
- a layering step (20) during which at least one layer of a printable material (120) is arranged on said textured surface made electrically conductive;
- a step of pressing (30) a mould (130) comprising cavities or protrusions so as to transfer the cavities or the protrusions of the mould (130) into the printable material (120) to form patterns (132) there;
- a step of removing (40) the mould leaving the patterns (132) to appear in the printable material (120);
- a step of stripping (50), at the bottom of the patterns, said textured surface;
- a step of electrodepositing (60) at least one material which is a conductor or semiconductor of electricity in the patterns (132) to form conductive or semi-conductive patterns (140, 150) from said textured surface of the substrate made electrically conductive.

**2.** Method according to the preceding claim, wherein said reliefs (102) of said textured surface having an amplitude greater than ten times the minimum width of said patterns (132).

**3.** Method according to the preceding claim, wherein said reliefs (102) of said textured surface having an amplitude greater than the minimum width of said patterns (132) and wherein the patterns have a width preferably of between 10nm and 100µm.

**4.** Method according to any one of the preceding claims, wherein said reliefs (102) of the textured surface have an inverted or non-inverted pyramid shape and/or a cylindrical shape with an inverted or non-inverted circular cross-section and/or inverted or non-inverted polygon shape and/or form waves and/or grooves.

**5.** Method according to any one of the preceding claims, wherein the preparation step (10) comprises a step consisting of obtaining a base substrate (100) of which the surface is textured and a step of forming an amorphous silicon layer (160) covering at least partially said textured surface.

**6.** Method according to any one of the preceding claims, wherein the preparation step (10) comprises a step consisting of doping a base substrate (100) with charge carriers so as to make it electrically conductive or semi-conductive.

**7.** Method according to any one of the preceding claims, wherein the preparation step (10) comprises a step consisting of obtaining a base substrate (100) of which the surface is textured and a step of covering at least partially said textured surface by an electrically conductive layer (110) and wherein the electrically conductive layer (110) is preferably a tin-doped indium oxide (ITO) layer.

**8.** Method according to any one of the preceding claims, wherein after the electrodeposition step (60), an annealing step is carried out.

**9.** Method according to any one of the preceding claims, wherein the electrodeposition step (60) is carried out such that the conductive or semi-conductive patterns (150) form a protrusion beyond the printable material (120) or is carried out such that the conductive or semi-conductive material forms a protrusion beyond the reliefs (102) of the textured surface.

**10.** Method according to any one of the preceding claims, wherein the printable material is transparent and wherein the printable material (120) is conserved after the electrodeposition step (60).

**11.** Method according to any one of claims 1 to 9 comprising after the electrodeposition step, a step of removing, at least partially, the printable material.

**12.** Method according to any one of the preceding claims, wherein the printable material (120) is a photosensitive resin, wherein the mould (130) comprises a masking coating (134) partially stopping at least the exposure of the resin that it covers selectively, either only outside of the patterns or only on at least one of the patterns, and comprising, before the step of removing the mould (130), an exposure step to activate the resin non-masked by the masking coating (134) and wherein the resin is a positive resin and the masking coating (134) covers the mould (130) outside of the end of the patterns or wherein the resin is a negative resin and the masking coating (134) covers the mould (130) on the end at least of the patterns.

13. Method according to any one of the preceding claims, wherein during the layering step, the volume of the layer of a printable material (120) arranged on said textured surfaces is equal to $V_{layer}$, with

$$V_{layer} = V_{Mould} + V_{Fill} + V_{safety}$$

with:

$V_{Mould}$ = the volume defined by the patterns of the mould,
$V_{Fill}$ = the free volume between the textured surface and a plane which is parallel to the substrate and which passes through the highest point of the relief of greatest amplitude,
$V_{safety}$ = (surface of the substrate) x (safety thickness), the safety thickness (220, $e_s$) being the distance between the highest peak of the relief of the textured surface and the end of the patterns of the mould,

and wherein the safety thickness $e_s$ is defined as follows:

$$(e_s) \leq 2H_m - (A)$$

with:

A = distance between the highest point and the lowest point of the textured surface,
$H_m$ = height of the patterns of the mould.

14. Method according to any one of the preceding claims, wherein if the ratio of the shape of the reliefs of the textured surface is greater than or equal to 3, thus defines the mould such that the width of the patterns of the mould is greater than the minimum width of the reliefs of the textured surface.

15. Method for producing several photovoltaic cells comprising a method according to any one of the preceding claims.

102

104

100

## Figure 1a

10

110

100

## Figure 1b

20

120

110

100

## Figure 1c

30

132

130

120

110

100

## Figure 1d

Figure 1e

Figure 1f

Figure 1g

Figure 1h

Figure 2

**Figure 3a**

**Figure 3b**

**Figure 3c**

Figure 4

Figure 5

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 20100120191 A